# EUROPEAN PATENT APPLICATION

(11) **EP 1 248 149 A1**
(43) Date of publication of application: **09.10.2002**
(21) Application number: 01107826.8
(22) Date of filing: 06.04.2001
(51) Int. Cl.: G03F 7/023

(54) **Photosensitive lithographic printing plate**

(71) Applicant: FUJI PHOTO FILM CO., LTD., Kanagawa (JP)
(72) Inventor: Fujita, Kasuo, Yoshida-cho, Haibara-gun, Shizuoka (JP); Tan, Shiro, Yoshida-cho, Haibara-gun, Shizuoka (JP)
(74) Representative: HOFFMANN - EITLE

(57) **Abstract**

Provided is a photosensitive lithographic printing plate having a photosensitive layer comprising an o-naphthoquinonediazide compound and a vinyl-polymerized polymer compound which is insoluble in water and soluble in alkaline aqueous solutions, with the vinyl-polymerized polymer compound being a copolymer of at least a specified monomer having an alkali-soluble group and an acrylamide or methacrylamide compound, thereby ensuring a wide development latitude, excellent resistance to abrasion and chemicals, no scumming and high impression capacity even in the case of using UV printing ink.

## Description

### FIELD OF THE INVENTION

The present invention relates to a photosensitive lithographic printing plate. More specifically, the invention is concerned with a photosensitive lithographic printing plate which has a photosensitive layer comprising a positively working photosensitive compound and a polymer compound having excellent abrasion resistance and chemical resistance, possesses a wide development latitude and develops no scumming at the time of printing.

### BACKGROUND OF THE INVENTION

Photosensitive compositions comprising o-naphthoquinonediazide compounds and phenolic resins of novolak type have been regarded as very excellent and industrially used for production of lithographic printing plates and as photoresist materials.

However, the novolak type of phenolic resins used as the main constituent of a lithographic printing plate cannot ensure the printing plate a sufficient impression capacity because they have poor adhesion to substrates, form brittle films and have inferior coatability and abrasion resistance. Further, they are poor in chemical resistance, so that the press life of the printing plate becomes very short, particularly when the printing ink used is UV ink.

For the purpose of improving those properties, burning treatment (namely heating treatment carried out after exposure and development) is generally employed. However, the burning treatment has a drawback of tending to cause sublimation of low molecular-weight compounds from image areas of a photosensitive layer; as a result, the sublimed compounds adhere to non-image areas and thereby scumming develops.

With the intention of solving such problems, various polymer compounds have been examined for binder capabilities. For instance, the poly(hydroxystyrene) and hydroxystyrene copolymers disclosed in JP-B-52-41050 (the term "JP-B" as used herein means an "examined Japanese patent publication") exhibit improved film properties, indeed, but they also have a drawback of being inferior in abrasion resistance and chemical resistance. Further, JP-A-51-34711 (the term "JP-A" as used herein means an "unexamined published Japanese patent application") proposes using as a binder a polymer compound containing constitutional units of an acrylic acid derivative in its molecular structure. Such a polymer compound has problems of being narrow in development latitude and having insufficient abrasion resistance. Furthermore, JP-A-2-866 proposes employing as a binder a polymer compound having sulfonamido groups. In addition, JP-A-63-89864, JP-A-1-35436, JP-A-1-52139 and JP-A-8-339082 propose utilizing as binders polymer compounds containing constitutional units of acrylic acid derivatives having phenolic hydroxyl structures in their molecular structures. However, the abrasion resistance thereof is still insufficient, and the lithographic printing plates using them have a drawback of tending to develop scumming.

### SUMMARY OF THE INVENTION

Therefore, an object of the invention is to provide a photosensitive lithographic printing plate which is developable with an aqueous alkaline developer and has high resistance to abrasion and great impression capacity.

Another object of the invention is to provide a photosensitive lithographic printing plate which is highly resistant to chemicals and has a long press life even when it undergoes printing operations using UV ink (UV-curable ink) without receiving burning treatment.

Still another object of the invention is to provide a photosensitive lithographic printing plate which has a wide development latitude and develops no scumming.

A further object of the invention is to provide a photosensitive lithographic printing plate comprising a photosensitive layer which has good adhesion to a substrate, sufficient pliability and high solubilities in organic solvents.

As a result of our studies on various comonomer compositions of vinyl polymers, it has been found that the aforementioned objects of the invention can be attained when the photosensitive layer of a photosensitive lithographic printing plate is made up of a photosensitive composition comprising a photosensitive compound and a vinyl copolymer prepared by copolymerizing at least a monomeric compound having an alkali-soluble group and an acrylamide or methacrylamide compound which may be substituted at the nitrogen site, thereby achieving the invention.

More specifically, an embodiment of the invention relates to a photosensitive lithographic printing plate having a photosensitive layer comprising an o-naphthoquinonediazide compound and a vinyl-polymerized polymer compound which is insoluble in water and soluble in aqueous alkaline solutions, characterized in that the polymer compound is a copolymer of at least the following monomers (A) and (B):
(A) an alkali-soluble group-containing compound represented by the following formula (I): 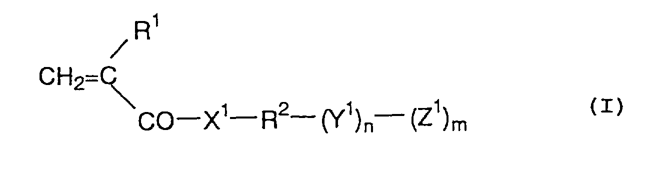 wherein X¹ represents -O- or -NR³-, R¹ represents -H or -CH₃, R² represents a single bond or a divalent organic group, Y¹ represents an arylene group, Z¹ represents a group having an acidic hydrogen atom, n represents 0 or 1, but n is 1 when R² is a single bond and Z¹ is -OH, m represents an integer of at least 1, and R³ represents a hydrogen atom or an alkyl, cycloalkyl, aryl or aralkyl group containing up to 12 carbon atoms;
(B) an acrylamide or methacrylamide compound represented by the following formula (II) : 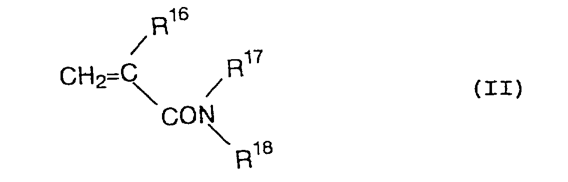
wherein R¹⁶ represents -H or -CH₃, and R¹⁷ and R¹⁸ each represent a hydrogen atom or an alkyl, cycloalkyl, aryl or aralkyl group containing up to 12 carbon atoms.

### DETAILED DESCRIPTION OF THE INVENTION

Ingredients of a photosensitive composition used for a photosensitive layer of the present photosensitive lithographic printing plate are illustrated below in detail.

The water-insoluble, aqueous alkali-soluble, vinyl-polymerized polymer compound used in the invention is a polymer compound prepared by copolymerizing at least (A) a monomeric compound containing an alkali-soluble group and (B) an acrylamide or methacrylamide compound which may be substituted at the nitrogen site. The copolymerization of these monomers is effected in an appropriate solvent by the use of a known polymerization initiator.

The present monomeric compound (A) containing an alkali-soluble group includes compounds represented by the following formula (I): 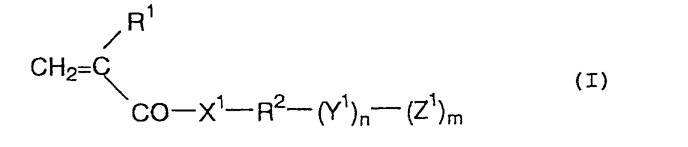 wherein X¹ represents -O- or -NR³-; R¹ represents -H or -CH₃; R² represents a single bond or a divalent organic group; Y¹ represents an arylene group; Z¹ represents -OH, -COOH, -SO₂NHR⁴, -NHSO₂R⁵, -CONHSO₂R⁶, -SO₂NHCOR⁷, -NHCONHSO₂R⁸, -SO₂NHCONHR⁹, -CONHSO₂MHR¹⁰, -NHSO₂NHCOR¹¹, -SO₂NHSO₂R¹², -COCH₂COR¹³, -OCONHSO₂R¹⁴ or -SO₂NHCOOR¹⁵; n represents 0 or 1, but n is 1 when R² is a single bond and Z¹ is -OH; m represents an integer of at least 1; R³ represents a hydrogen atom, or an unsubstituted or substituted alkyl, cycloalkyl, aryl or aralkyl group containing up to 12 carbon atoms; R⁴, R⁹ and R¹⁰ each represent a hydrogen atom, or an unsubstituted or substituted alkyl, cycloalkyl, aryl or aralkyl group containing up to 12 carbon atoms ; and R⁵, R⁶, R⁷, R⁸, R¹¹, R¹², R¹³, R¹⁴ and R¹⁵ each represent an unsubstituted or substituted alkyl, cycloalkyl, aryl or aralkyl group containing up to 12 carbon atoms.

Of compounds represented by formula (I) , the compounds which are particularly suitable for the invention are those containing a phenylene or naphthylene group as Y¹, -OH, -COOH, -SO₂NHR⁴ or -NH₂SO₂R⁵ as Z¹, and having n=1 and m= 1 or 2. When X¹ in those compounds is -NR³-, R³ is a hydrogen atom, R⁴ is a hydrogen atom, a 1-3C alkyl group or an unsubstituted or substituted phenyl group, and R⁵ is a 1-3C alkyl group or an unsubstituted or substituted phenyl group. As to the divalent organic group represented by R², there is no particular restriction so long as the group can link X¹ to Y¹ or Z¹ when n is 0. However, as suitable examples of R², mention may be made of unsubstituted and substituted alkylene, cycloalkylene and arylene groups wherein an ester, amido, imido, ether, urethane or urea linkage may be contained. Of these groups, the group especially suitable as R² of the invention is a single bond, an alkylene group or an alkylene group containing a linkage group.

Examples of a low molecular weight compound represented by formula (I) include the compounds as disclosed in JP-A-63-89864, JP-A-63-226641, JP-A-2-866, JP-A-8-39082 and JP-A-2000-250216. Of such compounds, the following Compounds (M1) to (M20) are preferred in particular.

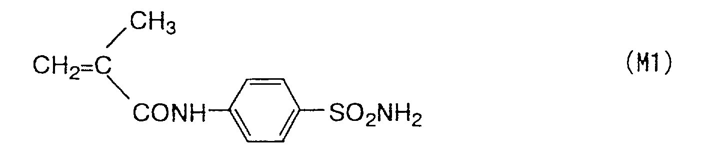

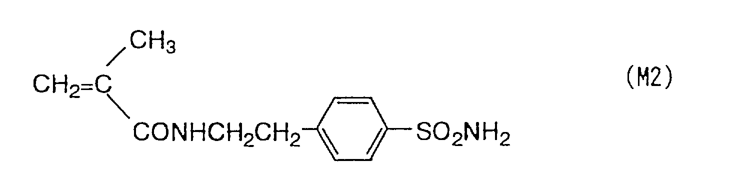

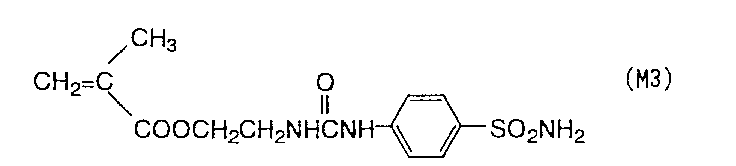

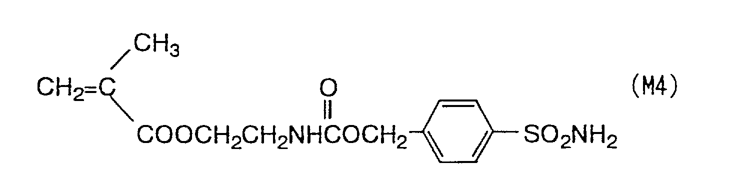

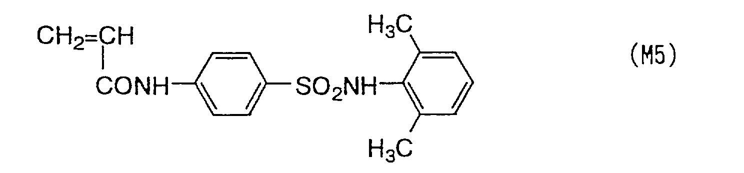

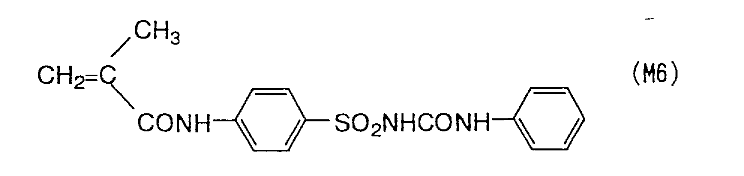

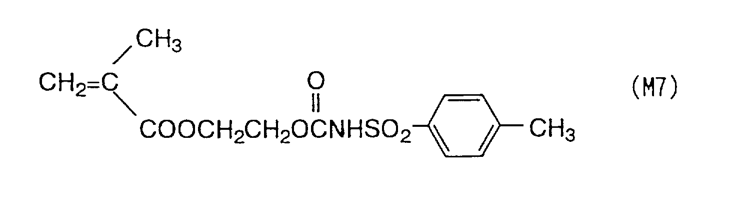

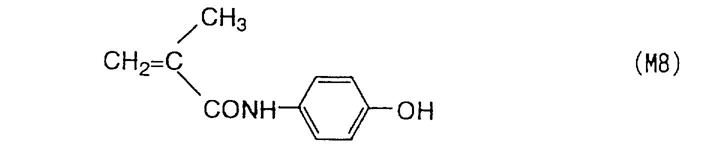

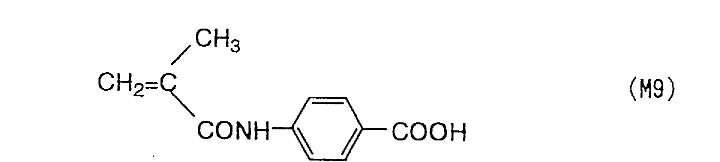

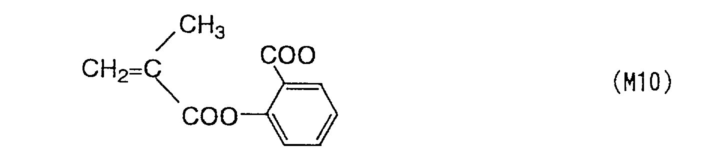

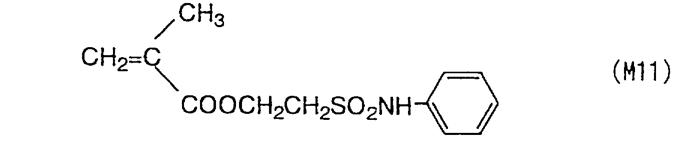

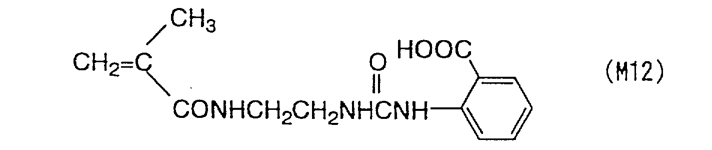

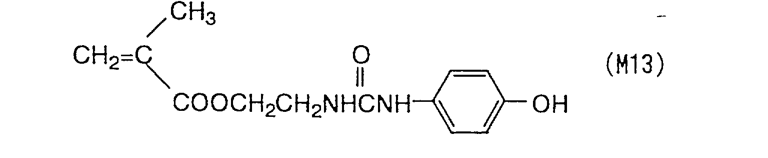

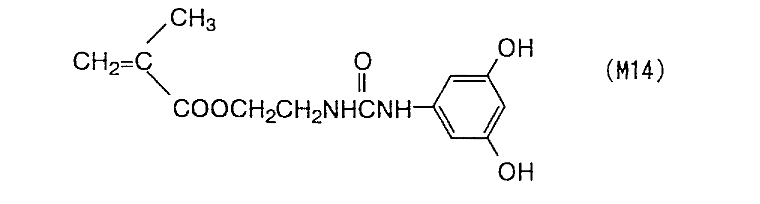

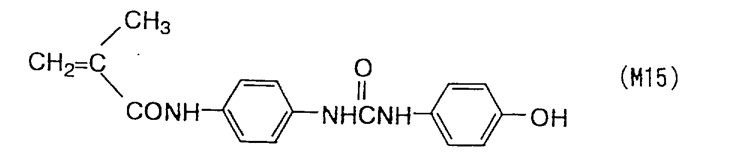

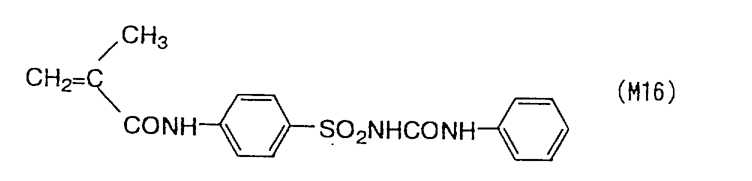

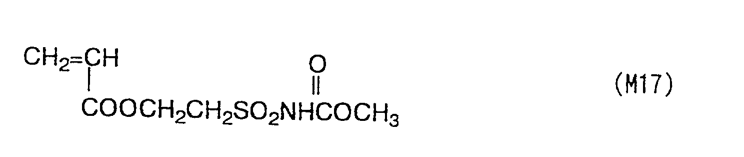

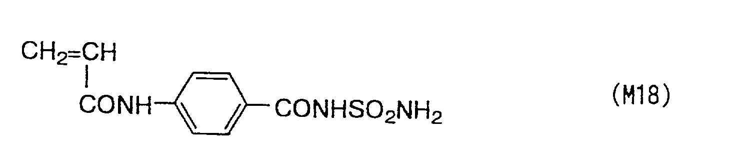

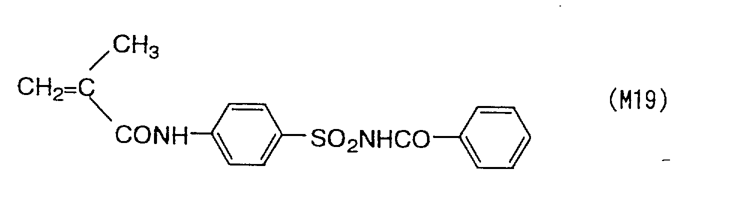

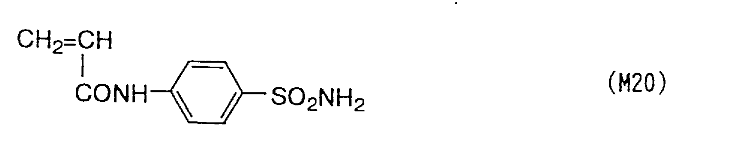

For rendering the present vinyl-polymerized polymer compound insoluble in water and soluble in aqueous alkaline solutions, it is appropriate that the proportion of an alkali-soluble group-containing Compound (A) in the polymer compound be within the range of 1 to 40 mole %, preferably 10 to 35 mole %. The proportions lower than 1 mole % or higher than 40 mole % are unsuitable, because the former causes poor development or scumming and the latter leads to image deletion or deterioration of impression capacity.

Examples of an N-substituted or N-unsubstituted acrylamide or methacrylamide Compound (B) include compounds represented by the following formula (II): 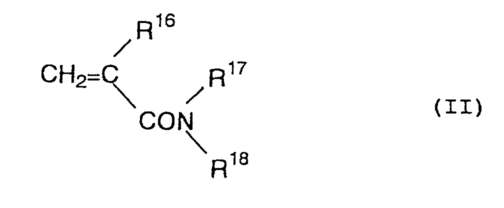 wherein R¹⁶ represents -H or -CH₃; and R¹⁷ and R¹⁸ each represent a hydrogen atom, or a substituted or unsubstituted alkyl, cycloalkyl, aryl or aralkyl group containing up to 12 carbon atoms.

Of the low molecular weight compounds represented by formula (II), those containing as each of the substituents R¹⁷ and R¹⁸ a hydrogen atom or a 1-6C alkyl group are preferred over the others. In particular, the compounds can be used to advantage when either R¹⁷ or R¹⁸ is a hydrogen atom or both R¹⁷ and R¹⁸ are hydrogen atoms . Examples of such compounds include acrylamides, such as acrylamide, N-methylacrylamide, N-ethylacrylamide, N-n-propylacrylamide, N-iso-propylacrylamide, N-n-butylacrylamide, N-iso-butylacrylamide, N-sec-butylacrylamide, N-tert-butylacrylamide, N-n-pentylacrylamide, N-n-hexylacrylamide and diacetoneacrylamide; and methacrylamides, such as methacrylamide, N-methylmethacrylamide, N-ethylmethacrylamide, N-n-propylmethacrylamide, N-iso-propylmethacrylamide, N-n-butylmethacrylamide, N-iso-butylmethacrylamide, N-sec-butylmethacrylamide, N-tert-butylmethacrylamide, N-n-pentylmethacrylamide, N-n-hexylmethacrylamide and diacetonemethacrylamide.

For rendering the present vinyl-polymerized polymer compound insoluble in water and soluble in aqueous alkaline solutions, it is appropriate that the proportion of an N-substituted or N-unsubstituted acrylamide or methacrylamide Compound (B) in the polymer compound be within the range of 1 to 50 mole %, preferably 5 to 30 mole %. The proportions lower than 1 mole % or higher than 50 mole % are unsuitable, because the former causes poor development or scumming and the latter leads to image deletion.

The polymer compound used in the invention may be a copolymer of at least one Compound (A) , which contains an alkali-soluble group, and at least one acrylamide or methacrylamide Compound (B) which may be substituted at the nitrogen site, but it is advantageous for the copolymer to further contain monomeric units derived from at least one compound having at least one polymerizable unsaturated bond but being free of an alkali-soluble group contained in formula (I) and an acrylamido or methacrylamido group contained in formula (II).

Such a compound as to have at least one polymerizable unsaturated bond but be free of an alkali-soluble group contained in formula (I) and an acrylamido or methacrylamido group contained in formula (II) is a compound selected from acrylic acid, methacrylic acid, acrylic acid esters, methacrylic acid esters, styrenes, acrylonitrile, or methacrylonitrile.

Examples of acrylic acid esters usable herein include alkyl acrylates (preferably containing 1 to 10 carbon atoms in the alkyl moiety) , such as methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, furfuryl acrylate and tetrahydrofurfuryl acrylate; and aryl acrylates, such as phenyl acrylate. Examples of methacrylic acid esters usable herein include alkyl methacrylates (preferably containing 1 to 10 carbon atoms in the alkyl moiety) , such as methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate and tetrahydrofurfuryl methacrylate; and aryl methacrylates, such as phenyl methacrylate, cresyl methacrylate and naphthyl methacrylate. Examples of styrenes usable herein include styrene, alkylstyrenes (such as methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethyl-styrene and acetoxymethylstyrene), alkoxystyrenes (such as methoxystyrene, 4-methoxy-3-methylstyrene and dimethoxy-styrene), and holostyrenes (such as chlorostyrene, dichlorostyrene, trichlorostyrene, tetrachlorostyrene, pentachlorostyrene, bromostyrene, dibromostyrene, iodo-styrene, fluorostyrene, trifluorostyrene, 2-bromo-4-trifluoromethylstyrene and 4-fluoro-3-trifluoromethyl-styrene).

Of those polymerizable unsaturated bond-containing compounds, methacrylates, acrylates, acrylonitrile, methacrylonitrile, methacrylic acid and acrylic acid are preferred. In particular, acrylonitrile and methacrylonitrile are advantageous over the others.

One or more of those compounds can be used as copolymerizing components of the present polymer compound. The suitable proportion of these optional copolymerizing components in the present polymer compound is from 0 to 80 mole % , preferably from 30 to 80 mole %.

The copolymer of at least one low molecular weight compound represented by formula (I) and at least one low molecular weight compound represented by formula (II), and optionally at least one polymerizable unsaturated bond-containing compound as recited above may be any of block, random and graft copolymers.

As examples of a solvent usable in the synthesis of such a polymer compound, mention may be made of ethylene dichloride, cyclohexanone, methyl ethyl ketone, acetone, methanol, ethanol, ethylene glycol monomethyl ether, ethylene glycol monoethyl ether, 2-methoxyethylacetate, 1-methoxy-2-propanol, 1-methoxy-2-propylacetate, N,N-dimethylformamide, N,N-dimethylacetamide, dimethyl sulfoxide, toluene, ethyl acetate, methyl lactate and ethyl lactate.

These solvents may be used alone or as a mixture of two or more thereof.

It is appropriate that the present polymer compound have a weight average molecular weight of at least 2,000, preferably from 5,000 to 300,000, and a number average molecular weight of at least 1,000, preferably from 2,000 to 250,000. The suitable polydispersity (weight-average molecular weight/number-average molecular weight) is at least 1, preferably from 1.1 to 10.

In addition, the present polymer compound may contain monomers remaining unreacted. In this case, it is desirable that the proportion of such monomers in the polymer compound be at most 15 weight %.

Polymer compounds according to the invention may be used alone or as a mixture of two or more thereof. The suitable content of such polymer compound(s) in the present photosensitive composition is from about 5 to about 95 % by weight, preferably from about 10 to about 85 % by weight.

O-naphthoquinonediazide compounds appropriately used in the invention include the esters formed from 1,2-diazonaphthoquinonesulfonic acid chloride and pyrogallol-acetone resins as disclosed in JP-B-43-28403.

Other o-quinonediazide compounds suitable for the invention include the esters formed from 1,2-diazonaphthoquinonesulfonic acid chloride and phenol-formaldehyde resins as disclosed in U.S. Patents 3,046,120 and 3,188,210. Further, there are other o-naphthoquinonediazide compounds known to be useful by the reports in many patents. As examples of such useful o-naphthoquinonediazide compounds, mention may be made of the compounds disclosed in JP-A-47-5303, JP-A-48-63802, JP-A-48-63803, JP-A-48-96575, JP-A-49-38701, JP-A-48-13354, JP-B-37-18015, JP-B-41-11222, JP-B-45-9610, JP-B-49-17481, U.S. Patents 2,797,213, 3,454,400, 3,544,323, 3,573,917, 3,674,495 and 3,785,825, British Patents 1,227,602, 1,251,345, 1,267,005, 1,329,888 and 1,330,932, and German Patent 854,890.

The o-naphthoquinonediazide compounds used to particular advantage in the invention are compounds prepared by reaction of polyhydroxy compounds having molecular weights of at most 1,000 with 1,2-diazonaphthoquinonesulfonic acid chloride. Examples of these compounds include those disclosed in JP-A-51-139402, JP-A-58-150948, JP-A-58-203434, JP-A-59-165053, JP-A-60-121445, JP-A-60-134235, JP-A-60-163043, JP-A-61-118744, JP-A-62-10645, JP-A-62-10646, JP-A-62-153950, JP-A-62-178562, Japanese Patent Application No. 62-233292, and U.S. Patents 3,102,809, 3,126,281, 3,130,047, 3,148,983, 3,184,310, 3,188,210 and 4,639,406.

In the synthesis of an o-naphthoquinonediazide compound as recited above, it is appropriate to use 1,2-diazonaphthoquinonesulfonic acid chloride in an amount of 0.2 to 1.2 equivalents, preferably 0.3 to 1.0 equivalent, to the hydroxyl groups in a polyhydroxy compound to react therewith.

The product obtained by the foregoing reaction is a mixture of o-naphthoquinonediazide compounds differing in position and number of the 1,2-diazonaphthoquinone sulfonate groups introduced. In this mixture, the suitable proportion of the compound formed by conversion of all the hydroxyl groups into 1,2-diazonaphthoquinone sulfonate groups (namely the completely esterified compound) is at least 5 mole %, preferably from 20 to 99 mole %.

The suitable proportion of o-naphthoquinonediazide compounds in the photosensitive layer of the present photosensitive lithographic printing plate is from 5 to 50 % by weight, preferably from 15 to 40 % by weight.

Besides containing the present polymer compounds having amide bonds, the photosensitive layer of the present photosensitive lithographic printing plate can contain known alkali-soluble polymer compounds, such as phenol-formaldehyde resin, cresol-formaldehyde resins (e.g., m-cresol-formaldehyde resin, p-cresol-formaldehyde resin, m-/p-cresol mixture-formaldehyde resin, phenol/cresol (m-cresol, p-cresol or m-/p-cresol mixture) mixture-formaldehyde resin), phenol-modified xylene resin, poly(hydroxystyrene) and poly(halogenated hydroxystyrene).

Those alkali-soluble polymer compounds are favorably used when they have weight-average molecular weights in the range of 500 to 20,000 and number-average molecular weights in the range of 200 to 60,000.

Such alkali-soluble polymer compounds are added in a proportion of at most 70 % by weight to the total ingredients of the photosensitive composition.

Further, as described in U.S. Patent 4,123,279, the use of condensation products of phenols having 3-8C alkyl substituents and formaldehyde, such as tert-butylphenol-formaldehyde resin and octylphenol-formaldehyde resin, in combination with those alkali-soluble polymer compounds is effective in increasing the ink-receptivity of images.

To the photosensitive composition used for a photosensitive layer of the present photosensitive lithographic printing plate, it is advantageous to add cyclic acid anhydrides, phenols or/and organic acids for the purpose of increasing the photosensitivity.

Examples of cyclic acid anhydrides usable for such a purpose include those disclosed in U.S. Patent 4,115,128, such as phthalic anhydride, tetrahydrophthalic anhydride, hexahydrophthalic anhydride, 3,6-endoxo- Δ ⁴-tetrahydro-phthalic anhydride, tetrachlorophthalic anhydride, maleic anhydrice, chloromaleic anhydride, α-phenylmaleic anhydride, succinic anhydride and pyromellitic anhydride.

Examples of phenols usable for the foregoing purpose include bisphenol A, p-nitrophenol, p-ethoxyphenol, 2,3,4-trihydroxybenzophenone, 4-hydroxybenzophenone, 2,4,4'-trihydroxybenzophenone, 4,4,4"-trihydroxytriphenylmethane and 4,4',3",4"-tetrahydroxy-3,5,3',5'-tetramethyltriphenyl-met hane.

As to organic acids usable for the foregoing purpose, JP-A-60-88942 and JP-A-2-96755 disclose sulfonic acids, sulfinic acid, alkylsulfates, phosphonic acids, phosphinic acids, phosphates and carboxylic acids. Examples of such acids include p-toluenesulfonic acid, dodecylbenzenesulfonic acid, p-toluenesulfinic acid, ethyl sulfate, phenylphosphonic acid, phenylsulfinic acid, phenyl phosphate, diphenyl phosphate, benzoic acid, isophthalic acid, adipic acid, p-toluylic acid, 3,4-dimethoxybenzoic acid, phthalic acid, terephthalic acid, 1,4-cyclohexene-2,2-dicarboxylic acid, erucic acid, lauric acid, n-undecanoic acid and ascorbic acid.

The suitable proportion of cyclic acid anhydrides, phenols or/and organic acids in the photosensitive composition is from 0.05 to 15 % by weight, preferably from 0.1 to 5 % by weight.

To the photosensitive layer of the present photosensitive lithographic printing plate, the nonionic surfactants as disclosed in JP-A-62-251740 and JP-A-4-68355 or/and the amphoteric surfactants as disclosed in JP-A-59-121044 and JP-A-4-13149 can further be added with the intention of widening development latitude. Examples of such nonionic surfactants include sorbitan tristearate, sorbitan monopalmitate, sorbitan trioleate, stearic acid monoglyceride, polyoxyethylene-sorbitan monooleate and polyoxyethylene nonyl phenyl ether, and examples of such amphoteric surfactants include alkyldi(aminoethyl)glycine, alkylpolyaminoethylglycine hydrochloride, N-tetradecyl-N,N-betaine type surfactant (Amogen K, trade name, a product of Dai-ichi Kogyo Seiyaku Co., Ltd.), 2-alkyl-N-carboxyethyl-N-hydroxyethylimidazolinium betaine, and alkylimidazoline type surfactant (Lebon 15, trade name, a product of Sanyo Chemical Industries Co., Ltd.). The suitable proportion of those nonionic or/and amphoteric surfactants in the photosensitive composition is from 0.05 to 15 % by weight, preferably from 0.1 to 5 % by weight.

To the photosensitive layer of the present photosensitive lithographic printing plate, dyes or fillers can be added as a print-out or image-colorant for obtaining visible images immediately after exposure. Examples of dyes usable in the invention include the basic dyes disclosed in JP-A-5-313359, specifically the salts of cations having basic dye skeletons and organic anions which each have a sulfonic acid group alone as an individual exchanging group and contain at least 10 carbon atoms and 1 to 3 hydroxyl groups.

Such basic dyes can be added in a proportion of from 0.2 to 5 % by weight to the total ingredients of the photosensitive composition. Further, the compounds providing photolysis products which can react with the dyes disclosed in JP-A-5-313359 cited above to change their colors can be added to the present photosensitive composition. Examples of such compounds include the o-naphthoquinonediazide-4-sulfonic acid halides disclosed in JP-A-50-36209 (corresponding to U.S. Patent 3,969,118), the trihalomethyl-2-pyrones and the trihalomethyltriazines disclosed in JP-A-53-36223 (corresponding to U.S. Patent 4,160,671), the various o-naphthoquinonediazide compounds disclosed in JP-A-55-62444 (corresponding to U.S. Patent 2,038,801) and the 2-trihalomethyl-5-aryl-1,3,5-oxadiazole compounds disclosed in JP-A-55-77742 (corresponding to U.S. Patent 4,279,982). These compounds can be used alone or as a mixture of two or more thereof.

Dyes other than those disclosed in JP-A-5-313359 cited above can also be used as a colorant for images. The dyes suitable as a colorant for images include not only salt-forming organic dyes but also oil-soluble dyes and basic dyes.

For instance, Oil Green BG, Oil Blue BOS, Oil Blue #603 (which are products of Orient Kagaku Kogyo K.K.), Victoria Pure Blue BOH (a product of Hodogaya Chemical Co., Ltd.), Rhodamine B (CI45170B), Malachite Green (CI42000) and Methylene Blue (CI52015) can be suitably used as the colorant.

In preparing the present photosensitive lithographic printing plate, an aluminum plate treated so as to have water receptivity, such as a silicate-treated aluminum plate, an anodically oxidized aluminum plate, a grained aluminum plate or a silicate-electrodeposited aluminum plate, can be used as its substrate. In addition, a zinc plate, a stainless steel plate, a chromatized steel plate, a plastic film treated so as to have water receptivity and a paper sheet can also be used as the substrate.

Of these sheets, an aluminum plate is preferred over the others. The term "an aluminum plate" used herein is intended to include a sheet of pure aluminum and plates of aluminum alloys. Examples of a usable aluminum alloy include alloys of aluminum and various metals, such as silicon, copper, manganese, magnesium, chromium, zinc, lead, bismuth and nickel. These alloy compositions contain negligibly small amounts of impurities in addition to some amounts of iron and titanium.

The aluminum plate is subjected to surface treatment, if needed. Examples of suitable surface treatment include graining treatment, immersion treatment in a water solution of sodium silicate, potassium fluorozirconate or phosphate, and anodic oxidation treatment. Further, the aluminum plate having undergone immersion treatment in a water solution of sodium silicate after graining treatment as disclosed in U.S. Patent 2,714,066, and the aluminum plate having undergone immersion treatment in a water solution of alkali metal silicate after anodic oxidation treatment as disclosed in U.S. Patent 3,181,461 are also used to advantage. The anodic oxidation treatment as mentioned above can be effected by passing an electric current through an electrolytic solution in which an aluminum plate is placed as anode. As examples of a electrolytic solution usable therein, mention may be made of an aqueous or non-aqueous solution of inorganic acid, such as phosphoric acid, chromic acid, sulfuric acid or boric acid, an aqueous or non-aqueous solution of organic acid, such as oxalic acid or sulfamic acid, or an aqueous or non-aqueous solution of salt formed from an acid as recited above, and a mixture of two or more of the solutions recited above.

In addition, the silicate electrodeposition as disclosed in U.S. Patent 3,658,662 is also effective.

The surface treatments recited above are carried out not only for imparting water receptivity to the substrate surface but also for preventing harmful reactions from occurring between the substrate and a photosensitive composition coated thereon and enhancing the adhesion between the substrate and the photosensitive layer.

Prior to the graining treatment, the aluminum plate surface may be subjected to pre-treatments for removing rolling oil and baring clean aluminum surface, if needed. For the former purpose, solvents, such as trichlene, and surfactants are employed; while, for the latter purpose, alkaline etching agents, such as sodium hydroxide and potassium hydroxide, are generally employed.

The graining treatment can be effected using any of mechanical, chemical and electrochemical methods. As the mechanical methods, there are known a ball abrasion method, a blast abrasion method and a brush abrasion method comprising rubbing an aqueous slurry of abrasive, such as pumice, with a nylon brush. As to the chemical graining method, the method as disclosed in JP-A-54-31187, which comprises immersing an aluminum plate in a saturated water solution of aluminum salt of mineral acid, is suitably employed. As the electrochemical graining method, the method of graining by application of AC to an electrolyte containing an acid, such as hydrochloric acid, nitric acid or a mixture thereof, is used to advantage. Of these graining methods, the combination of a mechanical graining method with an electrochemical graining method as disclosed in JP-A-55-137993 is preferred over the others because it can provide strong adhesion between the substrate and the ink-receptive image.

It is effective to carry out the graining treatment using any of the aforementioned methods so that the aluminum plate surface has a center line average roughness (Ra) in the range of 0.3 to 1.0 µm.

The thus grained aluminum plate is washed and then chemically etched, if desired.

The solution for etching treatment is generally selected from aqueous solutions of bases or acids capable of dissolving aluminum. However, it is required for the etching solution not to form on the etched surface a film other than aluminum film. Examples of an etching agent satisfying such a requirement include basic substances, such as sodium hydroxide, potassium hydroxide, trisodium phosphate, disodium phosphate, tripotassium phosphate and dipotassium phosphate, and acidic substances such as sulfuric acid, persulfuric acid, phosphoric acid, hydrochloric acid and salts thereof. On the other hand, the salts of metals having ionization tendency weaker than aluminum, such as zinc, chromium, cobalt, nickel and copper, are undesirable because they form unnecessary films on the etched surface.

For the etching treatment, it is most desirable to determine the etching agent concentration and the temperature of the etching solution used so that the dissolution rate of aluminum or aluminum alloy used is in the range of 0.3 to 40 g/m² per minute of immersion time. However, the dissolution rate may be below or above the foregoing range.

The etching treatment is carried out by immersing an aluminum plate in the etching solution as recited above or coating an aluminum plate with the etching solution as recited above, and the suitable amount of aluminum etched by this treatment is from 0.5 to 10 g/m².

Although the foregoing bases are preferred as etching agents because the aqueous solutions thereof have high etching rates, they cause generation of smut. Therefore, the aluminum plate etched with an aqueous solution of base is generally subjected to desmut treatment. For the desmut treatment, nitric acid, sulfuric acid, phosphoric acid, chromic acid, hydrofluoric acid or borofluoric acid can be used.

The etched aluminum plate is subjected to washing and anodic oxidation treatments, if needed. The anodic oxidation treatment can be effected using any of conventional methods. More specifically, an anodically oxidized film can be formed on an aluminum substrate surface by applying a direct or alternating current to the aluminum substrate in an aqueous or non-aqueous solution of sulfuric acid, phosphoric acid, chromic acid, oxalic acid, sulfamic acid, benzenesulfonic acid or a mixture of two or more thereof.

The treatment conditions for anodic oxidation vary according to the electrolytic solution used, so they cannot be generalized. However, it is practically appropriate that the electrolyte concentration be from 1 to 80 % by weight, the solution temperature from 5 to 70°C, the current density from 0.5 to 60 amperes/dm², the voltage from 1 to 100 V and the electrolysis time from 0.5 minute (i.e., 30 seconds) to 50 minutes.

In particular, it is advantageous to carry out the anodic oxidation using the method of applying a high current density to the aluminum substrate in sulfuric acid as disclosed in U.K. Patent 1,412,768, or the method of utilizing phosphoric acid as an electrolytic bath as disclosed in U.S. Patent 3,511,661.

The aluminum plate grained and further anodized in the aforementioned manners may further undergo a treatment for rendering the sheet surface water-receptive (i.e., hydrophilic treatment) , if desired. Examples of a method suitable for this treatment include the method as disclosed in U.S. Patents 2,714,066 and 3,181,461, specifically the treatment with alkali metal silicates (e.g., an aqueous solution of sodium silicate) , the method as disclosed in JP-B-36-22063, specifically the treatment with potassium fluorozirconate, and the method disclosed in U.S. Patent 4,153,461, specifically the treatment with polyvinylsulfonic acid.

The aluminum plate grained, anodized and further, if needed, rendered water-receptive may be coated with a subbing layer comprising a water-soluble compound. Examples of such a water-soluble compound include those disclosed in JP-B-57-16349. Other examples of a material which can constitute a subbing layer include a combination of a water-soluble metal salt and hydrophilic cellulose (such as the combination of zinc chloride and carboxymethyl cellulose, or the combination of magnesium chloride and hydroxyethyl cellulose), the polyacrylic amide disclosed in U.S. Patent 3,511,661, the polyvinylphosphonic acid disclosed in JP-B-46-35685, the amino acids and their salts disclosed in JP-A-60-149491 (such as alkali metal salts (e.g., sodium salts, potassium salts), ammonium salts, hydrochlorides, oxalates, acetates and phosphates of amino acids) and the hydroxyl group-containing amines and their salts disclosed in JP-A-60-232998. Of these compounds, the hydroxyl group-containing amines and their salts are preferred in particular. The suitable coverage of the subbing layer comprising such a water-soluble compound is from 1 to 80 mg/m² on a solids basis.

All the aforementioned ingredients of the present photosensitive composition are dissolved in an appropriate solvent, and coated on a substrate as described above to prepare a photosensitive lithographic printing plate. Examples of a solvent used herein include γ-butyrolactone, ethylene dichloride, cyclohexanone, methyl ethyl ketone, ethylene glycol monomethyl ether, ethylene glycol monoethyl ether, 2-methoxyethylacetate, 1-methoxy-2-propanol, 1-methoxy-2-propylacetate, toluene, ethyl acetate, methyl lactate, ethyl lactate, dimethyl sulfoxide, dimethylacetamide, dimethylformamide, water, N-methylpyrrolidone, tetrahydro-furfuryl alcohol, acetone, diacetone alcohol, methanol, ethanol, isopropanol and diethylene glycol dimethyl ether. These solvents can be used alone or as a mixture of two or more thereof. The suitable concentration of ingredients (solids) in the coating solution is from 2 to 50 % by weight. The suitable coverage of the present photosensitive composition depends on the intended use. For instance, it is generally from 0.5 to 3.0 g/m² on a solids basis in the case of using the composition for a photosensitive lithographic printing plate. Although the decrease in coverage of the photosensitive composition brings about an increase in photosensitivity, the physical properties of the photosensitive coating become poor.

To the photosensitive layer of the present photosensitive lithographic printing plate, surfactants for improving coatability, e.g., the fluorine-containing surfactants disclosed in JP-A-62-170950, can be added. The suitable proportion of such surfactants in the photosensitive composition is from 0.01 to 1 % by weight, preferably 0.05 to 0.5 % by weight. The surface of the photosensitive layer formed in the foregoing manner is preferably matted for the purpose of shortening the evacuation time upon contact exposure using a vacuum flame and preventing the printed image from blurring. As examples of a method for rendering the photosensitive layer surface matte, mention may be made of the methods of providing the matte layers as disclosed in JP-A-50-125805, JP-B-57-6582 and JP-B-61-28986 respectively, and the method of attaching solid particles to the layer surface by heat seal as disclosed in JP-B-62-62337.

The developers suitable for the present photosensitive lithographic printing plate are aqueous alkaline solutions containing substantially no organic solvents, with examples including aqueous solutions of sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium carbonate, sodium hydrogen carbonate, potassium carbonate and potassium hydrogen carbonate, and aqueous ammonia. The suitable concentration of these solutions is within the range of 0.1 to 10 weight %, preferably 0.5 to 5 weight %. Of those developers, the developers containing alkali silicates, such as potassium silicate, lithium silicate and sodium silicate, are preferred over the others because it becomes hard for the printing plates processed therewith to develop scumming. As to the suitable composition of alkali silicates contained in the developer, the [SiO₂]/[M] ratio is in the range of 0.5 to 2 . 5 by mole (wherein [SiO₂] stands for a molar concentration of SiO₂ and [M] stands for a molar concentration of the total alkali metals). Further, it is advantageous for the developers to have their SiO₂ concentrations in the range of 0.8 to 8 weight %. To these developers may be added water-soluble sulfites, such as sodium sulfite, potassium sulfite and magensium sulfite, resorcin, methylrecorcin, hydroquinone and thiosalycilic acid. The suitable proportion of these additives in the developer is from 0.002 to 4 % by weight, preferably from 0.01 to 1 % by weight.

By further containing at least one surfactant selected from among the anionic surfactants and the amphoteric surfactants as disclosed in JP-A-50-51324 and JP-A-59-84241 or the nonionic surfactants as disclosed in JP-A-59-75255, JP-A-60-111246 and JP-A-60-213943, and the polyelectrolytes as disclosed in JP-A-55-95946 and JP-A-56-142528, the developer can have enhanced ability to wet the photosensitive composition and improved consistency (stability) of development (development latitude). The suitable concentration of those surfactants in the developer is from 0.001 to 2 weight %, particularly preferably from 0.003 to 0.5 weight %. In addition, it is advantageous that the proportion of potassium to the total alkali metals of alkali silicates comprised in the developer be at least 20 mole %, preferably at least 90 mole %, and particularly preferably 100 mole %, because the generation of insoluble matter in the developer can be reduced.

Furthermore, a small amount of organic solvent such as alcohol, the chelating agents disclosed in JP-A-58-190952, the metal salts disclosed in JP-B-1-30139 and anti-foam fluid such as organosilane compounds can be added to the developers usable in the invention.

As a light source for exposure, a carbon arc lamp, a mercury lamp, a xenon lamp, a tungsten lamp and a metal halide lamp can be employed.

Needless to say, the photosensitive lithographic printing plates as mentioned above may undergo the prepress processing according to any of the methods disclosed in JP-A-54-8002, JP-A-55-115045 and JP-A-59-58431. More specifically, the developed photosensitive lithographic printing plate may be subjected to desensitizing treatment after or without washing, or may be processed with an aqueous solution containing an acid, or may be subjected to desensitizing treatment after treatment with an aqueous solution containing an acid. Since the aqueous alkali solution is consumed in proportion to the processing throughput in the development step to decrease its alkali concentration, or the alkali concentration is lowered by exposure to air during the long-term continuous operation of an automatic processor, the developer suffers from the lowering of processing capability. Under these circumstances, the processing capability may be regained by the use of a replenisher as disclosed in JP-A-54-62004. In this case, the replenishment is advantageously performed according to the method disclosed in U.S. Patent 4,882,246. Additionally, the platemaking processing is advantageously effected using the automatic processor as disclosed in JP-A-2-7054 or JP-A-2-32357.

In deleting unnecessary image areas after the present photosensitive lithographic printing plate is subjected sequentially to imagewise exposure, development and washing or rinsing, the deletion fluid as disclosed in JP-B-2-13293 is used to advantage. On the occasion when it is required to coat desensitizing gum on the present photosensitive lithographic printing plate at the final step of platemaking process, the desensitizing gum as disclosed in JP-B-62-16834, JP-B-62-25118, JP-B-63-52600, JP-A-62-7595, JP-A-62-11693 or JP-A-62-83194 can be favorably employed. Further, when the present photosensitive lithographic printing plate undergoes burning-in treatment after receiving sequentially imagewise exposure, development, washing or rinsing and further, if desired, deletion and washing, it is appropriate that the treatment with the burning conditioner as disclosed in JP-B-61-2518, JP-B-55-28062, JP-A-62-31859 or JP-A-61-159655 be carried out before the burning-in treatment.

Now, the invention is illustrated in more detail by reference to the following Synthesis Examples and Examples, but these examples should not be construed as limiting on or determinative of the scope of the invention.

### SYNTHESIS EXAMPLE 1

In a 200 ml three-necked flask equipped with a stirrer, a condenser and a dropping funnel, 3.60 g (0.015 mole) of N-(p-aminosulfonylphenyl)methacrylamide, 1.13 g (0.01 mole) of N-iso-propylacrylamide, 1.50 g (0.015 mole) of methyl methacrylate, 3.18 g (0.06 mole) of acrylonitrile and 20 g of N,N-dimethylacetamide were placed, and stirred as the flask was heated at 65°C in a hot water bath. To this mixture, 0.25 g of a polymerization initiator V-65 (trade name, a product of Wako Pure Chemical Industries, Ltd.) was added, and stirred for 2 hours in a stream of nitrogen as the temperature was kept at 65°C. To the resulting reaction mixture, a mixture of 3.60 g of N-(p-aminosulfonylphenyl)methacrylamide, 1.13 g of N-iso-propylacrylamide, 1.50 g of methyl methacrylate, 3.18 g of acrylonitrile, 20 g of N,N-dimethylacetamide and 0.25 g of V-65 was further added dropwise from the dropping funnel over a 2-hour period. After the conclusion of dropwise addition, the mixture was further stirred for 2 hours at 65°C. At the conclusion of the reaction, 40 g of methanol was added, cooled, and poured into 2 liter of water with stirring. After stirring for additional 30 minutes, the reaction product was filtered off, and dried to yield 18 g of white solid. By gel permeation chromatography, it was confirmed that the thus produced polymer compound (referred to as the present polymer compound (a) , which is shown in Table 1) had a weight average molecular weight of 45,000 (by the polystyrene standard).

### SYNTHESIS EXAMPLES 2 TO 6

Polymer compounds (b) to (F) shown in Table 1 were each synthesized in the same manner as in Synthesis Example 1.

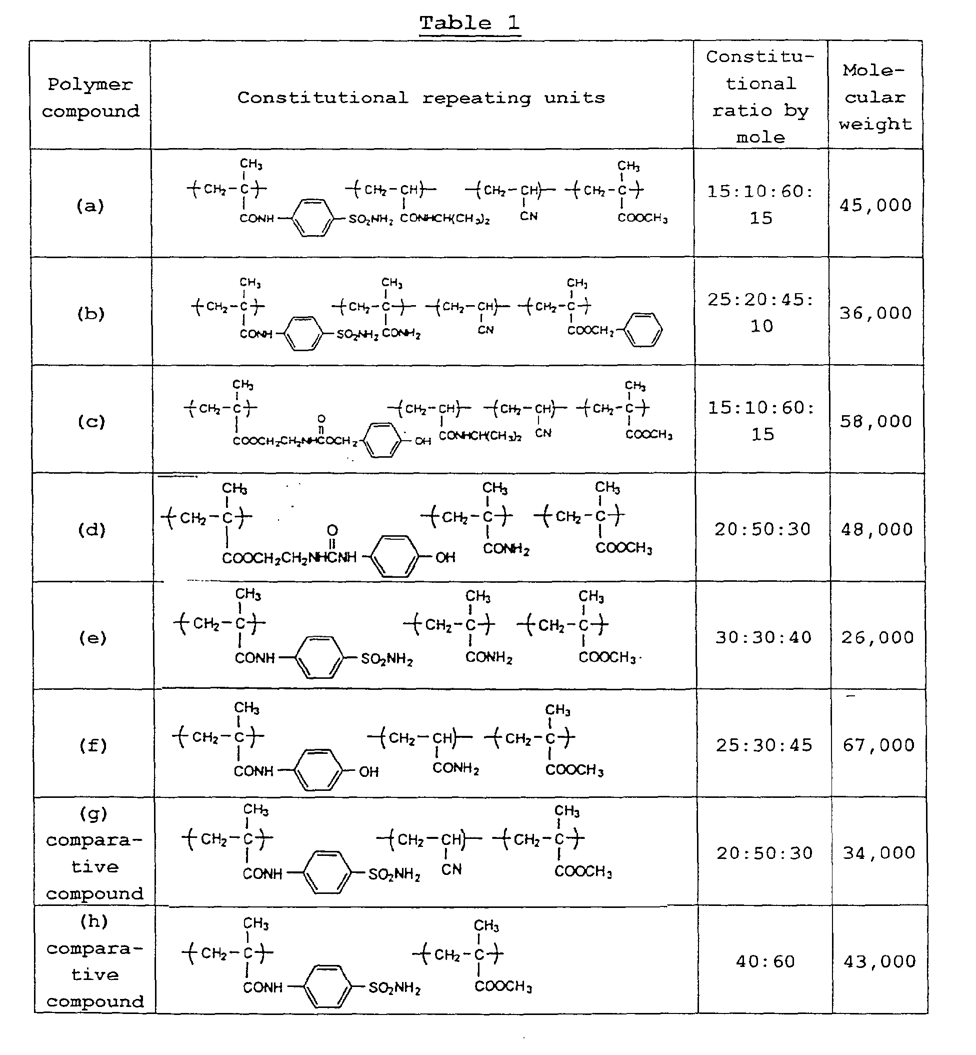

The invention is further illustrated by the following examples as preferred embodiments thereof. Additionally, "%" in the following examples and comparative examples is by weight unless otherwise noted.

### EXAMPLES 1 TO 9 AND COMPARATIVE EXAMPLES 1 TO 3

A 0.30 mm-thick aluminum plate was grained using a nylon brush and an aqueous suspension of 400-mesh pumice stone, and washed thoroughly with water. This grained plate was etched by 60-second immersion in a 10 % aqueous solution of sodium hydroxide kept at 70°C, washed with running water, rinsed with 20 % HNO₃ for neutralization, and further washed with water. Then, the thus etched plate underwent electrolytic treatment for roughening the surface thereof, wherein a 1 % aqueous solution of nitric acid was used as an electrolyte and an alternating current of sine-wave form was applied under the condition of V_{A} = 12.7 V so that the quantity of electricity at the anode was 160 Coulomb/dm². The surface roughness measurement showed that the thus treated sheet had a surface roughness of 0.6 µ, expressed in terms of Ra. Successively thereto, the aluminum plate was desmutted by 2-minute immersion in a 30 % aqueous solution of H₂SO₄ kept at 55°C, and further anodized in a 20 % aqueous solution of H₂SO₄ under the condition of a current density of 2 A/dm² till the anodic coating had a thickness of 2.7 g/m². Thus, the substrate was prepared.

On the surface of the substrate treated in the foregoing manner, a subbing layer composition (A) constituted of the following ingredients was coated, and dried at 80°C for 30 seconds. The dry coverage of the composition (A) was 30 mg/m².

| Subbing layer composition (A): | |
|---|---|
| Aminoethylphosphonic acid | 0.01 g |
| Phenylphosphonic acid | 0.15 g |
| Triethanolamine | 0.05 g |
| β-Alanine | 0.10 g |
| Methanol | 40 g |
| Purified water | 60 g |

The thus treated substrate is referred to as Substrate (I) .

On the Substrate (I) , the compositions categorized below as Photosensitive Composition (B) and those categorized below as Photosensitive Composition (C) were each coated at a coverage of 25 ml/m² by means of a rod coater, and then dried at 100°C for 1 minute. Thus, positive-working photosensitive lithographic printing plates [B]-1 to [B]-8 and [C]-1 to [C-4] were prepared respectively. Therein, the dry coverage of each composition was about 1.7 g/m².

Additionally, the present or comparative polymer compounds used in the photosensitive lithographic printing plates [B]-1 to [B]-8 and [C]-1 to [C]-4 are those shown in Table 1.

| Photosensitive Composition (B) | |
|---|---|
| Product of esterification between 2,3,4-tri-hydroxybenzophenone and naphthoquinone-1,2-diazide-5-sulfonyl chloride (esterification degree: 90 mole %) | 0.45 g |
| | |
| Cresol-formaldehyde novolak resin (meta/para ratio: 6/4, weight average molecular weight: 3,000, number average molecular weight: 1,100, unreacted cresol content: 0.7 %) | 0.2 g |
| | |
| m-Cresol-formaldehyde novolak resin (weight average molecular weight: 1,700, number average molecular weight: 600, unreacted cresol content: 1 %) | 0.3 g |
| | |
| Product of condensation between pyrogallol and acetone (weight average molecular weight: 2,200, number average molecular weight: 700) | 0.1 g |
| | |
| Present polymer compound (or comparative polymer compound) | 1.1 g |
| | |
| p-n-Octylphenol-formaldehyde resin (disclosed in U.S. Patent 4,123,279) | 0.02 g |
| | |
| Naphthoquinonediazide-1,2-diazide-4-sulfonic acid chloride | 0.01 g |
| | |
| Tetrahydrophthalic anhydride | 0.01 g |
| | |
| Benzoic acid | 0.02 g |
| | |
| 4-[p-N-(p-Hydroxybenzoyl)aminophenyl]-2,6-bis(trichloromethyl)-s-triazine | 0.02 g |
| | |
| N-(1,2-Naphthoquinone-2-diazide-4-sulfonyloxy)-cyclohexane-1,2-dicarboxylic acid imide | 0.01 g |
| | |
| Dye obtained by converting the counter anion of Victoria Pure Blue BOH (produced by Hodogaya Chemical Co., Ltd.) into 1-naphthalenesulfonic acid | 0.05 g |
| | |
| Curcumine | 0.005 g |
| | |
| 1-[α-Methyl-α-(4-hydroxy-3,5-dihydroxymethyl-phenyl)ethyl]-4-[α,α-bis(4-hydroxy-3,5-di-hydroxymethylphenyl)ethyl]benzene (Compound (X) disclosed in JP-A-6-282067) | 0.04 g |
| Megafac F-176 (fluorine-containing surfactant produced by Dai-Nippon Ink & Chemicals, Inc.) | 0.01 g |
| | |
| Methyl ethyl ketone | 10 g |
| | |
| γ-Butyrolactone | 5 g |
| | |
| 1-Methoxy-2-propanol | 5 g |

| Photosensitive Composition (C): | |
|---|---|
| Product of esterification between 2,3,4-tri-hydroxybenzophenone and naphthoquinone-1,2-diazide-5-sulfonyl chloride (esterification degree: 90 mole %) | 0.45 g |
| | |
| Present polymer compound (or compara-tive high moelcular compound) | 1.7 g |
| | |
| Naphthoquinonediazide-1,2-diazide-4-sulfonic acid chloride | 0.01 g |
| | |
| Tetrahydrophthalic anhydride | 0.02 g |
| | |
| Benzoic acid | 0.02 g |
| | |
| 4-[p-N-(p-Hydroxybenzoyl)aminophenyl]-2,6-bis(trichloromethyl)-s-triazine | 0.02 g |
| | |
| N-(1,2-Naphthoquinone-2-diazide-4-sulfonyloxy)-cyclohexane-1,2-dicarboxylic acid imide | 0.01 g |
| | |
| Dye obtained by converting the counter anion of Victoria Pure Blue BOH (produced by Hodogaya Chemical Co., Ltd.) into 1-naphthalenesulfonic acid | 0.05 g |
| | |
| Curcumine | 0.005 g |
| | |
| 1-[α-Methyl-α-(4-hydroxy-3,5-dihydroxymethyl-phenyl)ethyl]-4-[α,α-bis(4-hydroxy-3,5-di-hydroxymethylphenyl)ethyl]benzene (Compound (X) disclosed in JP-A-6-282067) | 0.04 g |
| | |
| Megafac F-176 (fluorine-containing surfactant produced by Dai-Nippon Ink & Chemicals, Inc.) | 0.01 g |
| | |
| Methyl ethyl ketone | 10 g |
| | |
| γ-Butyrolactone | 5 g |
| | |
| 1-Methoxy-2-propanol | 5 g |

A transparent positive original having line and halftone images was brought into close contact with the photosensitive layer of each of the photosensitive lithographic printing plates [B]-1 to [B]-8 and [C]-1 to [C]-4, and exposed by means of a carbon arc lamp of 30 ampere placed at a distance of 70 cm.

Each of the exposed photosensitive lithographic printing plates [B]-1 to [B]-8 and [C]-1 to [C]-4 was developed by 60-second immersion in a 25°C 1/8 aqueous solution of DP-4 (trade name, a product of Fuji Photo Film Co., Ltd.). Each of the thus obtained lithographic printing plates [B]-1 to [B]-8 and [C]-1 to [C]-4 was loaded in a printing press Model KOR made by Heidelberg A.G., and therefrom the line and halftone images were printed on woodfree quality paper sheets using commercially available ordinary ink or UV ink. By these operations, each printing plate was examined for net number of prints produced therefrom and scumming developed. The results obtained are shown in Table 2.

As can be seen from Table 2, each of the lithographic printing plates [B]-1 to [B]-6 and [C]-1 to [C]-3 using the present polymer compounds (Examples 1 to 9) provided a great number of prints in both cases of using ordinary ink and UV ink, compared with each of the lithographic printing plates [B]-7 and [B]-8 and [C]-4 (Comparative Examples 1 to 3). In other words, the present printing plates were superior in press life to the comparative ones. Further, the present plates were superior in anti-scumming properties also to the comparative plates.

**Table 2**

| Lithographic printing plate | Polymer compound used | Number of prints produced with ordinary ink | Number of prints produced with UV ink | Anti-scumming properties*) |
|---|---|---|---|---|
| [B]-1 Example 1 | (a) | 65,000 | 40,000 | good |
| [B]-2 Example 2 | (b) | 65,000 | 40,000 | good |
| [B]-3 Example 3 | (c) | 60,000 | 30,000 | good |
| [B]-4 Example 4 | (d) | 65,000 | 40,000 | good |
| [B]-5 Example 5 | (e) | 60,000 | 35,000 | good |
| [B]-6 Example 6 | (f) | 58,000 | 28,000 | good |
| [B]-7 Comparative Example 1 | (g) | 36,000 | 18,000 | very bad |
| [B]-8 Comparative Example 2 | (h) | 32,000 | 8,000 | good |
| [C]-1 Example 7 | (a) | 82,000 | 60,000 | good |
| [C]-2 Example 8 | (b) | 78,000 | 58,000 | good |
| [C]-3 Example 9 | (d) | 80,000 | 62,000 | good |
| [C]-4 Comparative Example 3 | (h) | 41,000 | 16,000 | very bad |

| | | | | |
|---|---|---|---|---|
| *) visual evaluation | | | | |

As the present photosensitive lithographic printing plate contains in its photosensitive layer a copolymer of at leastmonomers (A) and (B) illustrated above, the photosensitive layer can have good adhesion to a substrate, satisfactory pliability and high solubilities in organic solvents. Therefore, the present photosensitive layer can be coated on a substrate in a very good condition, and the exposed area thereof can be developed efficiently with an aqueous alkali developer. The relief images formed therein have high abrasion resistance and high adhesion to the substrate, so that when they are utilized as a printing plate a great number of prints of good quality can be obtained.

Further, the present photosensitive layer has excellent chemical resistance, and so it can provide a great number of prints of good quality even when it is subjected to the printing in UV ink without undergoing burning-in treatment. In other words, the present photosensitive lithographic printing plate can provide a lithographic printing plate having a long press life and developing no scumming.

## Claims

1. A photosensitive lithographic printing plate having a photosensitive layer comprising an o-naphthoquinonediazide compound and a vinyl-polymerized polymer compound which is insoluble in water and soluble in alkaline aqueous solutions, **characterized in that** the vinyl-polymerized polymer compound is a copolymer of at least the following monomers (A) and (B):
(A) an alkali-soluble group-containing compound represented by the following formula (I): 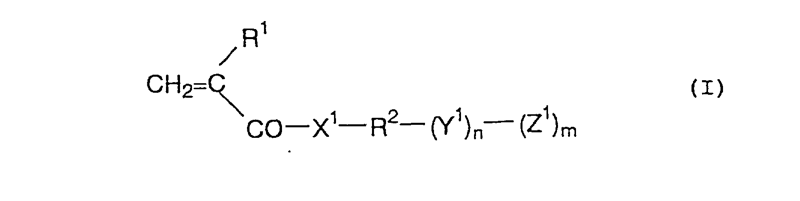 wherein X¹ represents -O- or -NR³-, R¹ represents -H or -CH₃, R² represents a single bond or a divalent organic group, Y¹ represents an arylene group, Z¹ represents a group having an acidic hydrogen atom, n represents 0 or 1, but n is 1 when R² is a single bond and Z¹ is -OH, m represents an integer of at least 1, and R³ represents a hydrogen atom or an alkyl, cycloalkyl, aryl or aralkyl group containing up to 12 carbon atoms;
(B) an acrylamide or methacrylamide compound represented by the following formula (II): 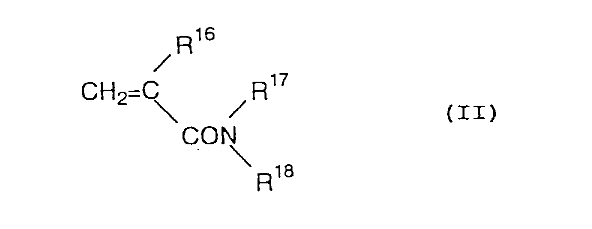 wherein R¹⁶ represents -H or -CH₃, and R¹⁷ and R¹⁸ each represent a hydrogen atom or an alkyl, cycloalkyl, aryl or aralkyl group containing up to 12 carbon atoms.

2. The photosensitive lithographic printing plate as claimed in claim 1, wherein in the formula (I) Z¹ represents - OH, -COOH, -SO₂NHR⁴, -NHSO₂R⁵, -CONHSO₂R⁶, -SO₂NHCOR⁷, -NHCONHSO₂R⁸, -SO₂NHCONHR⁹, -CONHSO₂MHR¹⁰, -NHSO₂NHCOR¹¹, -SO₂NHSO₂R¹², -COCH₂COR¹³, -OCONHSO₂R¹⁴ or -SO₂NHCOOR¹⁵; R⁴, R⁹ and R¹⁰ each represent a hydrogen atom, or an unsubstituted or substituted alkyl, cycloalkyl, aryl or aralkyl group containing up to 12 carbon atoms; and R⁵, R⁶, R⁷, R⁸, R¹¹, R¹², R¹³, R¹⁴ and R¹⁵ each represent an unsubstituted or substituted alkyl, cycloalkyl, aryl or aralkyl group containing up to 12 carbon atoms.

3. The photosensitive lithographic printing plate as claimed in claim 1, wherein in the formula (I) Y¹ is a phenylene or naphthylene group, Z¹ is -OH, -COOH, -SO₂NHR⁴ or -NH₂SO₂R⁵, n is 1 and m is 1 or 2.

4. The photosensitive lithographic printing plate as claimed in any one of the preceding claims, wherein the proportion of the alkali-soluble group-containing compound (A) in the polymer compound is within the range of 1 to 40 mole%.

5. The photosensitive lithographic printing plate as claimed in any one of the preceding claims, wherein the proportion of the alkali-soluble group-containing compound (A) in the polymer compound is within the range of 10 to 35 mole%.

6. The photosensitive lithographic printing plate as claimed in any one of the preceding claims, wherein in the formula (II) R¹⁷ and R¹⁸ each independently represents a hydrogen atom or an alkyl group having from 1 to 6 carbon atoms.

7. The photosensitive lithographic printing plate as claimed in any one of the preceding claims, wherein in the formula (II) at least one of R¹⁷ and R¹⁸ is a hydrogen atom.

8. The photosensitive lithographic printing plate as claimed in any one of the preceding claims, wherein the proportion of the acrylamide or methacrylamide compound (B) in the polymer compound is within the range of 1 to 50 mole%.

9. The photosensitive lithographic printing plate as claimed in any one of the preceding claims, wherein the proportion of the acrylamide or methacrylamide compound (B) in the polymer compound is within the range of 5 to 30 mole%.
